# EUROPEAN PATENT APPLICATION

(11) **EP 0 978 875 A1**
(43) Date of publication of application: **09.02.2000**
(21) Application number: 98830489.5
(22) Date of filing: 07.08.1998
(51) Int. Cl.: H01L 23/522, H01L 23/528

(54) **Integrated circuit comprising conductive lines with "negative" profile and related method of fabrication**

(71) Applicant: STMicroelectronics S.r.l., 20041 Agrate Brianza (Milano) (IT)
(72) Inventor: Bacchetta, Maurizio, 20127 Milano (IT); Vassalli, Omar, 24020 Pradalunga (Bergamo) (IT); Zanotti, Luca, 20041 Agrate Brianza (Milano) (IT)
(74) Representative: Mittler, Enrico

(57) **Abstract**

A semiconductor integrated circuit comprising lines of conductive material (4) for the electrical interconnection between parts of the circuit, and a layer of dielectric material (6), superimposed to the lines of conductive material (4). The lines of conductive material (4) have a vertical profile such that the smallest distance between two adjacent lines of conductive material is located at their upper surfaces.

## Description

The present invention relates to an integrated circuit with particular profile of the metal lines, in planarization processes with "air gaps" technique, and related method of fabrication.

The semiconductor integrated circuits obtained by means of large-scale integration technologies (LSI, VLSI, ULSI), with multiple levels of metal interconnections, require one or more process steps for defining an intermetal planarization.

The current techniques, used for defining intermetal planarization, are mainly two: the first technique provides for a silicon oxide deposition, a utilisation of a Spin On Glass (SOG) material, a subsequent partial dry etching, and, finally, a plasma enhanced chemical vapor deposition (PECVD) process; differently, the second technique, commonly used, provides for a high-density plasma chemical vapor deposition (HDPCVD) process, a subsequent oxide deposition and a chemical mechanical polishing (CMP) planarization.

In order to reduce the undesirable effects of capacitive coupling, crosstalking (crosstalk may be defined as a noise that appears in an inactive line due to interactions with dispersion electromagnetic fields originated by active lines), and the delay time constant RC, all effects that appear in presence of contiguous metal lines and with the dimension reduction existing in the technologies of fabrication of the semiconductor devices, some different solutions are provided for.

A solution is the utilisation of low k materials (wherein k is the dielectric constant), for example with k = 1,8 ― 3,5 at 1 MHz, instead of the silicon dioxide used in the intermetal process (the dielectric constant of the silicon dioxide is about k = 4 at 1 MHz).

Another solution provides for the complete elimination of the intermetal filling materials, creating "air gaps" (with a dielectric constant new to 1) between the contiguous metal lines.

The air gaps are formed as a consequence of the non-conformity of the plasma enhanced chemical vapor deposition process. The scalability and the process simplicity are the main advantages of the air gaps structures.

In the intermetal processes, the air gaps are formed selectively in the thin spaces comprised between the metal lines. The air gaps show a better reduction in the capacity coupling effect compared to the utilisation of low k materials, in particular in presence of very small spaces.

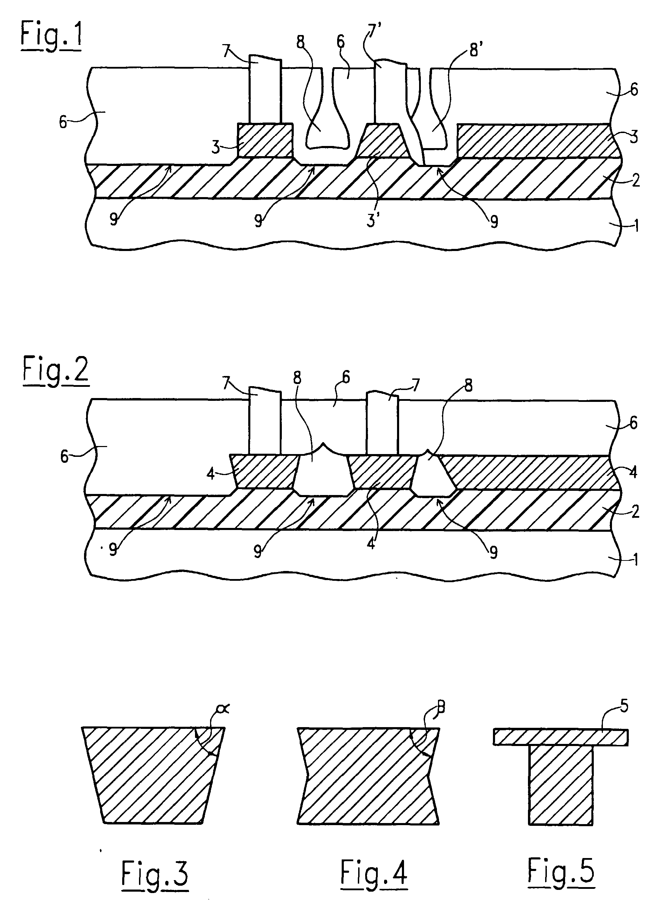

Figure 1 shows a cross-sectional view of an intermetal level of an integrated circuit. A field oxide layer 2 is superimposed on a silicon layer 1, and metal (for example Al or Cu) stripes 3 are present in the field oxide layer 2 for connecting parts of the integrated circuit. A dielectric material layer 6, called intermetal dielectric layer and usually comprising silicon (silicon dioxide, IMD USG), is deposited for insulating the metal lines 3 from other possible upper metal levels. Due to the fact that the deposition of such a dielectric material is not able to completely fill the spaces comprised between the metal lines 3, void zones 8 (air gaps) are formed inside these spaces.

Conductive metal elements 7 (vias) can be deposited over the metal stripes 3 for allowing the electrical connection between the different metal levels of the whole structure. The metal that is deposited for forming the vias 7, usually tungsten, can diffuse in the air gaps because of a not good alignment of the same vias, maybe for a reduced supporting surface on the upper part of the metal stripes, as shown in Figure 1, in which a metal stripe 3' is defined as having a "positive" profile, that is a profile with the lower part larger than the upper part, and the related vias 7' diffuse in the underlying air gap 8'. This fact can create problems of short-circuiting between a metal stripe and another adjacent one.

Figure 1 also shows overetch regions 9 of the field oxide 2, which are particularly advantageous because they allow to avoid edge effects of the capacity formed by two adjacent metal lines.

In view of the state of the art described, it has been an object of the present invention that of providing an integrated circuit comprising metal lines for the utilisation in intermetal planarization processes with air gaps technique, which resolves the above-mentioned problems.

According to the present invention, such an object is achieved by means of a semiconductor integrated circuit comprising lines of conductive material for the electrical interconnection between parts of said circuit, a layer of dielectric material, superimposed to said lines of conductive material, characterized in that said lines of conductive material have a vertical profile such that the smallest distance between two adjacent lines of conductive material is located at their upper surfaces.

The features and advantages of the present invention will be made clearer by the following detailed description of three particular embodiments thereof, illustrated as non-limiting examples in the annexed drawings, wherein:
Fig. 1 shows a cross-sectional view of an intermetal level of an integrated circuit, according to the prior art;
Fig. 2 shows a cross-sectional view of an intermetal level of an integrated circuit, according to a first embodiment of the present invention;
Figs. 3 to 5 show three different profiles of metal lines, according to three embodiments of the present invention.

Referring to Figure 2, a cross-sectional view similar to Figure 1 is shown, but wherein metal stripes 4 according to a first embodiment of the present invention are provided, that is with "negative" profiles, with the upper part larger than the lower part. Such a profile modifies the whole structure of the intermetal level because during the deposition of the intermetal dielectric material 6, due to the non-conformity of the deposition itself, an anticipated closure of the space between two adjacent metal lines at the upper surface of the metal lines 4 takes place, practically preventing the dielectric material 6 from penetrating in such a space.

Therefore, air gaps 8 are formed between adjacent metal stripes, and the air gaps 8 thus formed are deeper and larger than the air gaps usually obtained, as shown in Figure 1, because the upper part of the metal lines 4 does not allow the dielectric material to penetrate in the below regions, differently from Figure 1 wherein a part of the dielectric material 6 can penetrate between the metal lines. In this way the undesirable capacitive coupling effects are considerably reduced.

Moreover, the metal vias 7 are not subject to misalignment problems because the supporting surface on which they are deposited is larger than the one shown in Figure 1, and so the possible short-circuiting problems between adjacent metal stripes are avoided.

Figure 3 shows a cross-section profile of a metal stripe according to a first embodiment of the present invention (just described in Figure 2). The geometric form is a trapezoidal one with the lower base smaller than the upper base, in such a way that the smallest distance between two adjacent metal lines is located in the upper part, so that the space available for an undesirable introduction of dielectric material is reduced to a minimum. The α angle between the upper base and a side of the trapezium is preferably less than 85°.

Figure 4 shows a cross-section profile of a metal stripe according to a second embodiment of the present invention. The geometric form can be defined a "clepsydra" one, with the lower base approximately equal to the upper base. Also the β angle between the upper base of the trapezium and a side connected to the upper base itself, is preferably less than 85°.

Finally, Figure 5 shows a cross-section profile of a metal stripe according to a third embodiment of the present invention. The presence of an "overhang" (for example an anti reflecting layer, ARL) over the metal stripes allows to obtain the same results of the profiles previously described. All the profiles shown in Figures 3, 4 and 5 cause, in fact, the same effects in the morphology of the dielectric deposition PECVD, obtaining the desired air gaps.

To define profiles of metal stripes with the previously described geometrical features, it is necessary to achieve particular working points in the step of etching the metal layer during the process of fabrication. An example of possible value ranges for the metal etching step, is the following:
Pressure: 10-80 mTorr;
Top power: 300-800 W;
Bottom power: 50-500 W;
Flow Cl₂: 20-200 sccm;
Flow BCl₃: 10-100 sccm;
Flow N₂: 0-20 sccm.

## Claims

1. Semiconductor integrated circuit comprising lines of conductive material (4) for the electrical interconnection between parts of said circuit, a layer of dielectric material (6), superimposed to said lines of conductive material (4), characterized in that said lines of conductive material (4) have a vertical profile such tat the smallest distance between two adjacent lines of conductive material is located at their upper surfaces.

2. Circuit according to claim 1, characterized in that said lines of conductive material (4) have a trapezoidal profile with an upper base larger than the respective lower base, and an angle between said upper base and a connected side less than 85°.

3. Circuit according to claim 1, characterized in that said lines of conductive material (4) have a profile as a clepsydra one, with an upper base that is approximately equal to its respective lower base, and an angle between said upper base and a connected side less than 85°.

4. Circuit according to claim 1, characterized in that said lines of conductive material (4) have a "T" shape, with an overhang of metal material in their upper part.

5. Circuit according to anyone of the precedent claims, characterized by comprising several interconnection levels, each comprising lines of conductive material (4) and a layer of dielectric material (6) superimposed to them, according to anyone of the precedent claims.

6. Method of fabrication of a semiconductor integrated circuit comprising a step of deposition of a conductive material layer over an underlying insulating material (2), a step of etching of said conductive material layer for defining lines of electrical interconnection between parts of said circuit, and a step of chemical vapor deposition of a dielectric material layer over said lines, characterized in that said step of etching provides for forming lines of conductive material (4) with a profile according to anyone of the claims 1 to 4.
